# EUROPEAN PATENT APPLICATION

(11) **EP 2 552 020 A2**
(43) Date of publication of application: **30.01.2013**
(21) Application number: 12168387.4
(22) Date of filing: 16.05.2012
(51) Int. Cl.: H03H 9/10, H03H 9/05

(54) **Electronic device, oscillator, and method of manufacturing electronic device**

(30) Priority: 28.07.2011 JP 2011165291
(71) Applicant: Seiko Instruments Inc., Chiba-shi, Chiba (JP)
(72) Inventor: Yoshida, Yoshifumi, Chiba-shi, Chiba (JP)
(74) Representative: Miller Sturt Kenyon

(57) **Abstract**

An electronic device (1) is provided in which alignment of a lid substrate (2) and a base substrate (3) is facilitated to reduce the rate of occurrence of defects. The electronic device (1) according to the invention includes a lid substrate(2), a base substrate (3) bonded to the lid substrate (2) and forming a cavity (4) hermetically sealed from the outside air between the base substrate (3) and the lid substrate (2), an electronic element (5) housed in the cavity (4), and a mold member (6a, 6b) placed on an outer face of the lid substrate (2) or the base substrate (3). Thus, warping of the lid substrate (2) or the base substrate (3) is reduced.

## Description

The present invention relates to an electronic device including an electronic element mounted in a cavity formed between two substrates, an oscillator, and a method of manufacturing the electronic device.

Portable information terminals such as cellular phones widely available in recent years often employ electronic devices with small packages of a surface mount type. For example, a vibrator, a MEMS, a gyrosensor, an acceleration sensor or the like has a structure in which an electronic element is housed in a package of a hollow cavity structure. A known example of the package of the hollow cavity type is provided by anodic-bonding a base substrate to a lid substrate with a metal film interposed between them. A method of the anodic bonding is described, for example in JP-A-9-2845.

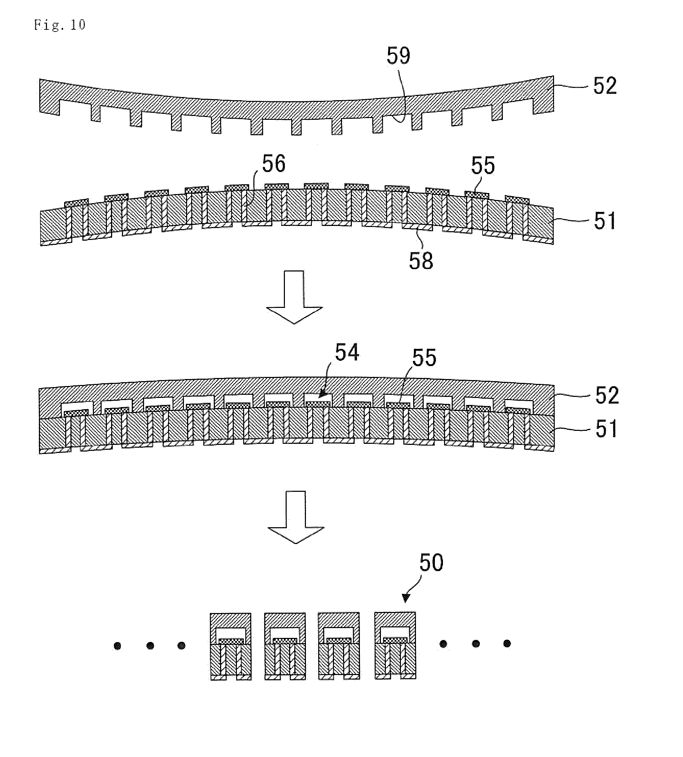

Fig. 10 shows a method of simultaneously forming a number of electronic devices 50 of this type. First, a base substrate 51 and a lid substrate 52 are prepared. Next, a plurality of through holes are formed in the base substrate 51, and a conductive material is embedded in each of the through holes to provide a through electrode 56. An electrode terminal 58 is formed on a back face of the base substrate 51 for electrical connection to the through electrode 56. A number of electronic elements 55 are mounted on a front face of the base substrate 51. In mounting of the electronic element 55, the electronic element 55 is electrically connected to the through electrode 56.

A number of recess portions 59 are formed in the lid substrate 52. Then, the base substrate 51 is overlaid on the lid substrate 52 and they are bonded together. The bonding is performed with an adhesive or anodic bonding. The recess portion 59 in the lid substrate 52 provides a cavity 54, and the electronic element 55 is housed in the cavity 54. Then, the substrates are split into individual electronic devices.

As shown in Fig. 10, however, the base substrate 51 and the lid substrate 52 are deformed when the through electrodes 56 and the recess portions 59 are formed. This reduces the accuracy of the alignment of the lid substrate 52 and the base substrate 51. Warping also occurs as shown in Fig. 10 after the bonding of the base substrate 51 to the lid substrate 52. The substrates are significantly warped, especially when the outer diameters of the base substrate 51 and the lid substrate 52 are increased to obtain a larger number of devices, which makes it difficult to align the base substrate 51 with the lid substrate 52. In addition, a change in ambient temperature changes the stress applied to the mounted electronic element 55, and the stress change disadvantageously varies the characteristics of the electronic element 55.

The invention has been made in view of the problems described above, and it is an object thereof to provide an electronic device with reduced deformation of a substrate, and a method of manufacturing the same.

An electronic device according to a first aspect of the invention includes a lid substrate, a base substrate bonded to the lid substrate and forming a cavity hermetically sealed from the outside air between the base substrate and the lid substrate, an electronic element housed in the cavity, and a mold member placed on an outer face of the lid substrate or the base substrate.

Preferably, the lid substrate has a recess portion and the recess portion forms the cavity.

Preferably, the base substrate has a through electrode passing from an inner face on the side of the cavity to an outer face on the side opposite to the cavity, and the electronic element is electrically connected to the through electrode.

Preferably, the lid substrate and the base substrate are bonded together with a bonding material including a metal material interposed between them.

Preferably, the electronic element is a crystal vibrator mounted in the form of a cantilever on the inner face of the base substrate.

Preferably, the mold member is formed of an epoxy resin.

An oscillator according to a second aspect of the invention includes the electronic device described in any of the above, and a driving circuit supplying a driving signal to the electronic device.

A method of manufacturing an electronic device according to a third aspect the invention includes a recess portion forming step of forming a recess portion in a lid substrate, a mounting step of mounting an electronic element on a base substrate, a mold member placing step of placing a mold member on an outer face of the lid substrate or the base substrate, and a bonding step of bonding the lid substrate to the base substrate with the electronic element housed in the recess portion.

Preferably, the mold member placing step is performed before the bonding step.

Preferably, the mold member placing step is performed after the bonding step.

Preferably, a through electrode forming step of forming a through electrode in the base substrate is further included, and the mold member placing step is a step of placing the mold member such that the through electrode is exposed on an outer face of the base substrate on the side opposite to the side where the electronic element is mounted.

Preferably, the recess portion forming step is a step of mounting a plurality of recess portions in the lid substrate, and the mounting step is a step of mounting a plurality of the electronic elements on the base substrate. A splitting step of cutting and splitting a stack formed of the lid substrate and the base substrate bonded together is included.

The electronic device according to the invention includes the lid substrate, the base substrate bonded to the lid substrate and forming the cavity between the base substrate and the lid substrate, the electronic element housed in the cavity, and the mold member placed on the outer face of the lid substrate or the base substrate. The mold member placed on the outer face of the lid substrate or the base substrate can reduce warping of the substrate to facilitate alignment of the lid substrate and the base substrate, thereby reducing the rate of occurrence of defects. In addition, variations in stress applied to the electronic element from the lid substrate or the base substrate can be reduced to stabilize the characteristics of the electronic element.

Embodiments of the present invention will now be described by way of further example only and with reference to the accompanying drawings, in which:
Fig. 1 is a schematic diagram in vertical section showing an electronic device according to a first embodiment of the invention.
Fig. 2 is a schematic diagram in vertical section showing an electronic device according to a second embodiment of the invention.
Fig. 3 is a schematic diagram in vertical section showing an electronic device according to a third embodiment of the invention.
Fig. 4 is an exploded perspective view showing the electronic device according to the third embodiment of the invention.
Fig. 5 is a schematic diagram of a top face showing an oscillator according to a fourth embodiment of the invention.
Fig. 6 is a process diagram showing a method of manufacturing an electronic device according to a fifth embodiment of the invention.
Fig. 7 is a diagram for explaining the method of manufacturing the electronic device according to the fifth embodiment of the invention.
Fig. 8 is a diagram for explaining the method of manufacturing the electronic device according to the fifth embodiment of the invention.
Fig. 9 is a diagram for explaining the method of manufacturing the electronic device according to the fifth embodiment of the invention.
Fig. 10 shows a method of simultaneously forming a number of electronic devices conventionally known.

### <Electronic Device>

An electronic device according to the invention includes a lid substrate, a base substrate bonded to the lid substrate and forming a cavity between the base substrate and the lid substrate, an electronic element housed in the cavity, and a mold member placed on an outer face of the lid substrate or the base substrate.

The configuration of the invention can reduce warping of the lid substrate or the base substrate to facilitate the alignment of the lid substrate and the base substrate, thereby reducing the rate of occurrence of defects. The reduced warping of the substrate allows the use of a large glass substrate from which a number of devices can be obtained, so that the cost of the electronic device can be cut. In addition, the reduced warping of the substrate relieves variations in stress applied to the electronic element resulting from a change in ambient temperature, which stabilizes the characteristics of the electronic element.

The lid substrate and the base substrate can be provided by using glass, ceramics, synthetic resin, or other materials. When a glass material is used, working thereof is easily performed and impregnation with water or other impurities can be prevented, and therefore, a package can be formed at low cost and with high reliability. The cavity may be formed of a recess portion formed in the lid substrate or a recess portion formed in the base substrate. The electronic element may be mounted on an inner face of the lid substrate or may be mounted on an inner face of the base substrate.

The mold member may be formed on the outer face of the lid substrate, may be formed on the outer face of the base substrate, or may be formed on each of the outer faces of both of the lid substrate and the base substrate. The mold member can be provided by using a resin material, for example an epoxy resin and a filler added thereto. The filler can be provided by using silica, alumina, alumina powder or the like. The coefficient of linear expansion of the mold member can be adjusted on the basis of the type and the amount of the filler. Since the mold member serves as the outer peripheral face of the electronic device, an identification number or the like can be marked on the mold member to ensure the specification of each product.

The lid substrate and the base substrate are bonded together by using an adhesive or can be anodic-bonded with a metal material interposed between them. The anodic bonding can provide a highly hermetic cavity. An electrical connection from the electronic element enclosed in the cavity to the outside can be made through an electrode formed on a bonding face of the lid substrate and/or the base substrate or can be made through a through electrode passing through the base substrate and/or the lid substrate.

### (First Embodiment)

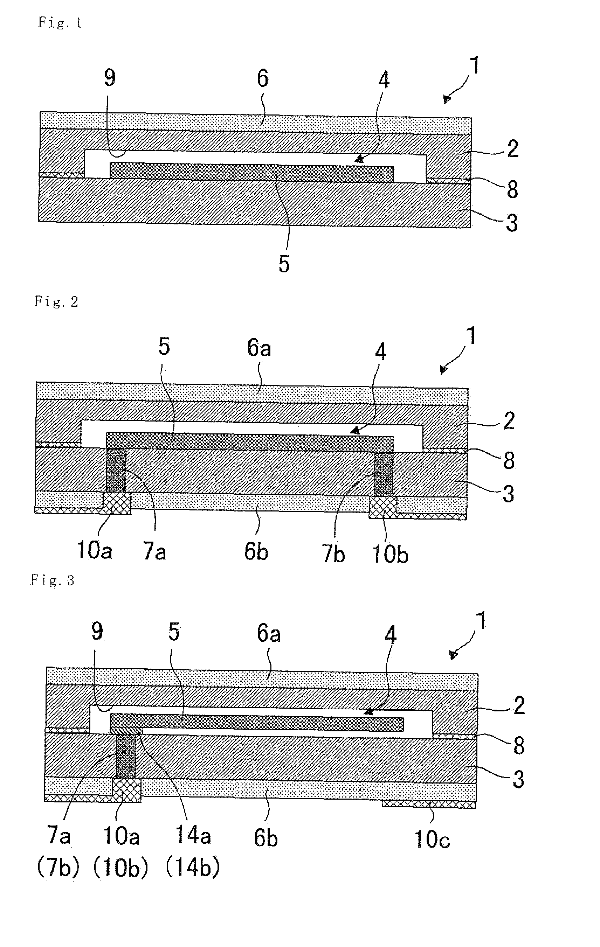

Fig. 1 is a schematic diagram in vertical section showing an electronic device 1 according to a first embodiment of the invention. The electronic device 1 includes a lid substrate 2 made of soda-lime glass, a base substrate 3 made of soda-lime glass, bonded to the lid substrate 2, and forming a cavity 4 hermetically sealed from the outside air between the base substrate 3 and the lid substrate 2, an electronic element 5 housed in the cavity 4 and surface-mounted on the base substrate 3, and a mold member 6 placed on an outer face of the lid substrate 2 on the side opposite to the cavity 4. The lid substrate 2 and the base substrate 3 are bonded together with a metal material 8 interposed between them. The cavity 4 is formed of a recess portion 9 formed in the lid substrate 2.

After the recess portion 9 is formed, the lid substrate 2 is easily warped such that the side of the recess portion 9 protrudes. To address this, the mold member 6 is placed on the surface of the lid substrate 2 on the side opposite to the recess portion 9. In this case, the soda-lime glass has a coefficient of linear expansion of 9 to 11 (ppm/°C), and the mold member 6 is set to have a coefficient of linear expansion smaller than that of the soda-lime glass. A mold material is applied to the surface of the lid substrate 2 and thermally cured at a temperature of 100°C or higher to form the mold member 6. When the mold member 6 is cooled to room temperature, the lid substrate 2 has the coefficient of linear expansion larger than the coefficient of linear expansion of the mold member 6 and thus the outer face of the lid substrate 2 is subjected to a compressive stress. Since this corrects the warping of the lid substrate 2 in which the side of the recess portion 9 protrudes, the lid substrate 2 is flattened. The coefficient of linear expansion of the mold member 6 can be adjusted by the type and the amount of the filler contained in the mold member 6. When epoxy resin filled with silica is used as the mold material, the filling amount of the silica can be increased to reduce the coefficient of linear expansion of the mold member 6.

Since the mold member 6 is placed on the outer face of the lid substrate 2 in this manner, the warping of the lid substrate 2 is reduced to facilitate the alignment of the lid substrate 2 and the base substrate 3. This allows the use of a large substrate from which a number of devices can be obtained, so that the cost of the electronic device can be reduced. In addition, the reduced warping of the electronic device 1 relieves variations in stress applied to the electronic element resulting from a change in ambient temperature, which stabilizes the characteristics of the electronic element.

### (Second Embodiment)

Fig. 2 is a schematic diagram in vertical section showing an electronic device 1 according to a second embodiment of the invention. The electronic device 1 includes a lid substrate 2 made of soda-lime glass, a base substrate 3 made of soda-lime glass, bonded to the lid substrate 2, and forming a cavity 4 hermetically sealed from the outside air between the base substrate 3 and the lid substrate 2, an electronic element 5 housed in the cavity 4 and surface-mounted on the base substrate 3, and mold members 6a and 6b placed on outer faces of the lid substrate 2 and the base substrate 3, respectively.

The electronic device 1 further includes through electrodes 7a and 7b passing through the base substrate 3, and electrode terminals 10a and 10b formed on an outer face of the mold member 6b and passing through the mold member 6b to electrically connect to the through electrodes 7a and 7b, respectively. The electronic element 5 is electrically connected to the through electrodes 7a and 7b through an electrode, not shown, and is mounted on the base substrate 3. Thus, the electronic element 5 can be supplied with power from the outside and can perform transmission to the outside through the electrode terminals 10a and 10b.

Since the mold member 6b is also placed on the outer face of the base substrate 3 in the present embodiment, warping of the base substrate 3 can be reduced. The coefficient of linear expansion of the mold member 6b may be adjusted on the basis of the warping of the base substrate 3 or warping of the lid substrate 2 and the base substrate 3 bonded together. For example when the base substrate 3 alone or the lid substrate 2 and the base substrate 3 bonded together are easily warped such that the side of the electronic element 5 protrudes, the coefficient of linear expansion of the mold member 6b may be set to be smaller than the coefficient of linear expansion of the soda-lime glass.

In addition, the mold member 6b serves as a shock-absorbing member when the electronic device 1 is mounted on a substrate or the like. Specifically, when the mold member 6b is not used, the through electrodes 7a and 7b are directly bonded to a mounting electrode on the substrate or the like in mounting the electronic device 1 on the substrate or the like. A large stress is applied to the through electrodes 7a and 7b in mounting the electronic device 1 or due to other environmental changes to cause a defect such as chipping or cracking in the base substrate 3 near the through electrodes 7a and 7b, for example the glass substrate. In contrast, the mold member 6b and the electrode terminals 10a and 10b are present between the electrode on the mounting substrate and the through electrodes 7a and 7b in the present embodiment, so that the stress applied to the base substrate 3 near the through electrodes 7a and 7b can be relieved to prevent occurrence of cracking or chipping in the base substrate 3.

Since the mold members 6a and 6b are placed on the outer faces of the lid substrate 2 and the base substrate 3 in this manner, the warping of each of the lid substrate 2 and the base substrate 3 is reduced to relieve the stress applied to the electronic element 5 to stabilize the characteristics. In addition, variations in stress applied to the electronic element resulting from a change in ambient temperature can be reduced to stabilize the characteristics of the electronic element. Furthermore, the mold members 6a and 6b can serve as the stress relieving layers to prevent the occurrence of cracking or chipping in the base substrate 3 due to environmental changes. Thus, the electronic device with stable characteristics, high reliability, and high quality can be provided. The mold members 6a and 6b may, but need not, have different coefficients of linear expansion.

### (Third Embodiment)

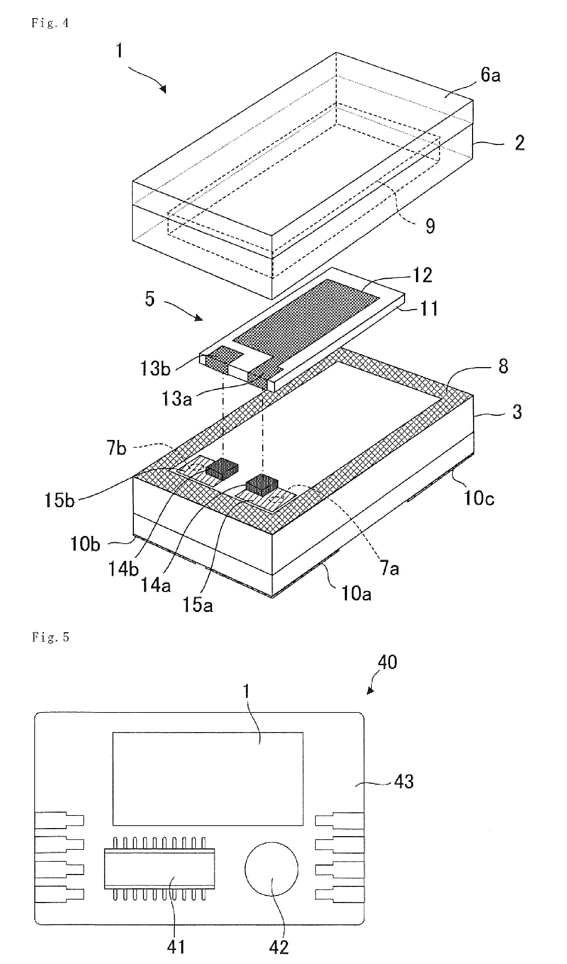

Fig. 3 and Fig. 4 are a schematic diagram in vertical section and an exploded perspective view showing an electronic device 1 according to a third embodiment of the invention, respectively. The third embodiment differs from the second embodiment in that an electronic element 5 is mounted in the form of a cantilever on a base substrate 3, and the other configurations are substantially similar to those of the second embodiment. In the following, description is mainly made of the different points. The same portions or the portions having the same functions are designated with the same reference numerals.

A lid substrate 2 and the base substrate 3 are anodic-bonded on the outer peripheral portions of the substrates by using a metal material 8 as a bonding material. The electronic element 5 is formed of a piezoelectric vibrating strip 11 made of monocrystalline crystal, an exciting electrode 12 formed on each face of the piezoelectric vibrating strip 11, and connecting electrodes 13a and 13b electrically connected to the exciting electrode 12. The electronic element 5 is mounted such that one end portion thereof is cantilevered on two mounting portions 14a and 14b. The two connecting electrodes 13a and 13b are connected to electrode terminals 10a and 10b (or 10c) through the mounting portions 14a and 14b, routing electrodes 15a and 15b, and through electrodes 7a and 7b, respectively, such that the electrodes 13a and 13b are electrically isolated from each other. When the lid substrate 2 and the base substrate 3 bonded together are easily warped with the side of the lid substrate 2 protruded, the coefficient of linear expansion of a mold member 6b can be set to be smaller than the coefficient of linear expansion of the lid substrate 2 or the base substrate 3, for example the coefficient of linear expansion of the soda-lime glass. Alternatively, when the lid substrate 2 and the base substrate 3 bonded together are easily warped with the side of the base substrate 3 protruded, the coefficient of linear expansion of the mold member 6b can be set to be larger than the coefficient of linear expansion of the soda-lime glass.

In the present embodiment, an AT-cut crystal vibrating strip is used as the piezoelectric vibrating strip 11. Each of the lid substrate 2 and the base substrate 3 has an outer diameter of approximately 2 mm x approximately 1 mm. Each of the lid substrate 2 and the base substrate 3 has a thickness of approximately 0.2 mm. Each of the mold members 6a and 6b has a thickness of approximately 50 µm. A recess portion 9 formed in the lid substrate 2 has a depth of approximately 0.1 mm. Vacuum is maintained in a cavity 4, and the vibrations of the piezoelectric vibrating strip 11 do not undergo air resistance.

Since the mold members 6a and 6b are placed on the outer faces of the lid substrate 2 and the base substrate 3 in this manner, the warping of each of the lid substrate 2 and the base substrate 3 is reduced to facilitate the alignment in bonding the lid substrate 2 to the base substrate 3, and the stress applied to the piezoelectric vibrating strip 11 is reduced to relieve variations in the vibration rate of the piezoelectric vibrating strip 11. In addition, the frequency characteristics are stabilized when the ambient temperature is changed. Furthermore, the mold member 6b can serve as a buffer member to prevent the occurrence of cracking or chipping in the base substrate 3 in mounting the electronic device 1 or due to other environmental changes. Since the mold members 6a and 6b serve as the outer peripheral face of the electronic device 1, an identification number or the like can be marked on the mold member 6a or 6b to ensure the specification of each product.

### <Oscillator>

### (Fourth Embodiment)

Fig. 5 is a schematic diagram of a top face showing an oscillator 40 according to a fourth embodiment of the invention. The oscillator 40 has the electronic device 1 incorporated therein which employs the piezoelectric vibrating strip 11 made of monocrystalline crystal shown in the third embodiment. As shown in Fig. 5, the oscillator 40 includes a substrate 43, the electronic device 1 placed on the substrate, an integrated circuit 41, and an electronic part 42. The electronic device 1 produces a signal at a certain frequency based on a driving signal supplied to the electrode terminals 10a and 10b. The integrated circuit 41 and the electronic part 42 process the signal at the certain frequency supplied from the electronic device 1 to produce a reference signal such as a clock signal. Since the electronic device 1 according to the invention can be formed with high reliability and small size, the overall oscillator 40 can be made compact.

### <Method of Manufacturing Electronic Device>

A method of manufacturing the electronic device according to the invention includes a recess portion forming step of forming the recess portion in the lid substrate, a mounting step of mounting the electronic element on the base substrate, a mold member placing step of placing the mold member on the outer face of one or both of the lid substrate and the base substrate, and a bonding step of bonding the lid substrate to the base substrate with the electronic element housed in the recess portion.

The mold member placed on the outer face of one or both of the lid substrate and the base substrate can reduce warping of the lid substrate or the base substrate to facilitate the alignment of the lid substrate and the base substrate. In addition, when the mold member is placed on the base substrate, the mounting of the electronic part can be facilitated at the mounting step to reduce the occurrence of defects. The reduced warping of the substrate allows the use of a large substrate from which a number of devices can be obtained, thereby cutting the cost of the electronic device. At the same time, variations in characteristics of the electronic element can be reduced when environmental changes occur, so that the quality of the electronic device can be improved.

### (Fifth Embodiment)

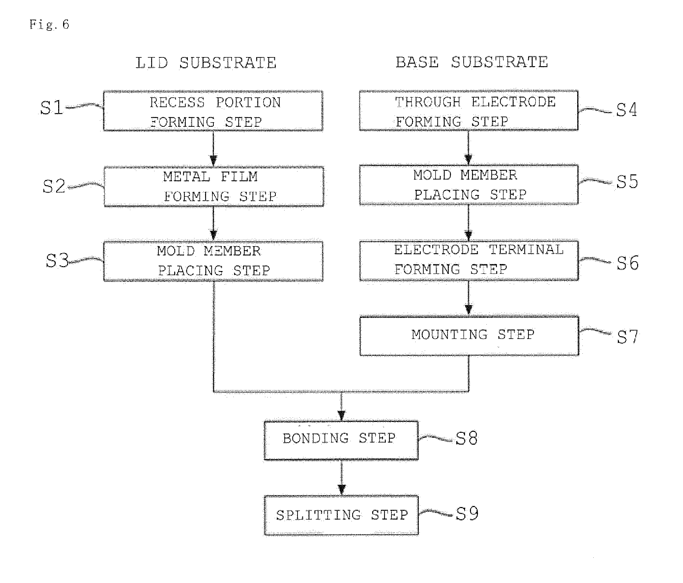

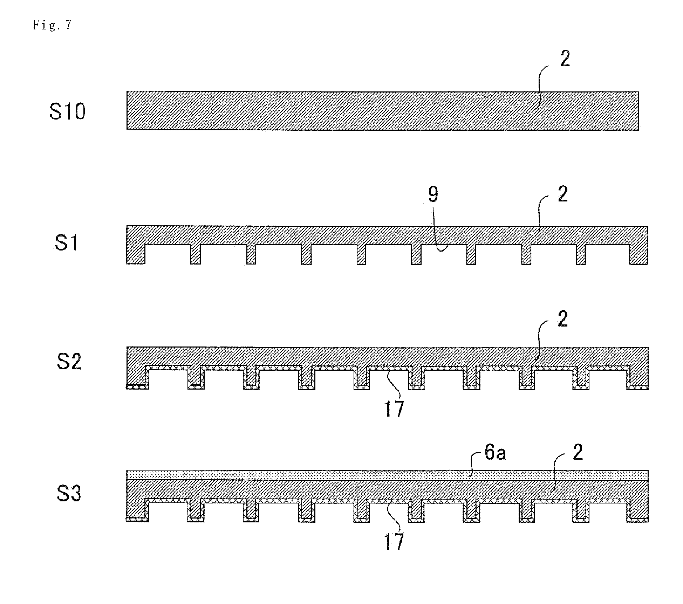

Fig. 6 to Fig. 9 are diagrams for explaining the method of manufacturing the electronic device according to a fifth embodiment of the invention. Fig. 6 is a process diagram showing the method of manufacturing the electronic device. Fig. 7, Fig. 8, and Fig. 9 are explanatory diagrams for the respective steps. In the present embodiment, soda-lime glass is used as the lid substrate 2 and the base substrate 3, and the electronic element 5 is formed of a crystal oscillator.

A method of manufacturing the lid substrate 2 is described with reference to Fig. 6 and Fig. 7. First, the lid substrate 2 in plate shape is prepared at a lid substrate preparing step S10. Next, the lid substrate 2 is placed in a mold with a molding method and is pressed while heating, thereby forming a plurality of recess portions 9 simultaneously. For example, a number of recess portions 9 having a depth of approximately 0.1 mm are simultaneously formed in a soda-lime glass plate having an outer diameter of 4 inches and a thickness of approximately 0.2 mm. A number of recess portions 9 may be formed simultaneously in this recess forming step S1 with a sandblast method or an etching method by placing a mask on the surface of the lid substrate 2, instead of the formation with the molding.

Next, at a metal film forming step S2, a metal film 17 made of aluminum containing amorphous silicon is deposited on the surface of the lid substrate 2 on the side of the recess portion 9 with a sputtering method. The metal film 17 is used as a bonding material between the lid substrate 2 and the base substrate 3 at a later step. The metal film 17 may be deposited with an evaporation method or a plating method. Another metal material can be used as required.

Next, at the mold member placing step S3, the mold member 6a is placed on the outer face of the lid substrate 2 on the side opposite to the recess portion 9. An epoxy resin material filled with silica is used as the mold material, is applied to the outer face of the lid substrate 2, and is cured through heating to a temperature of approximately 150C° to form the mold member 6a. The mold member 6a is formed with a thickness of 20 µm to 100 µm, preferably with a thickness of 50 µm.

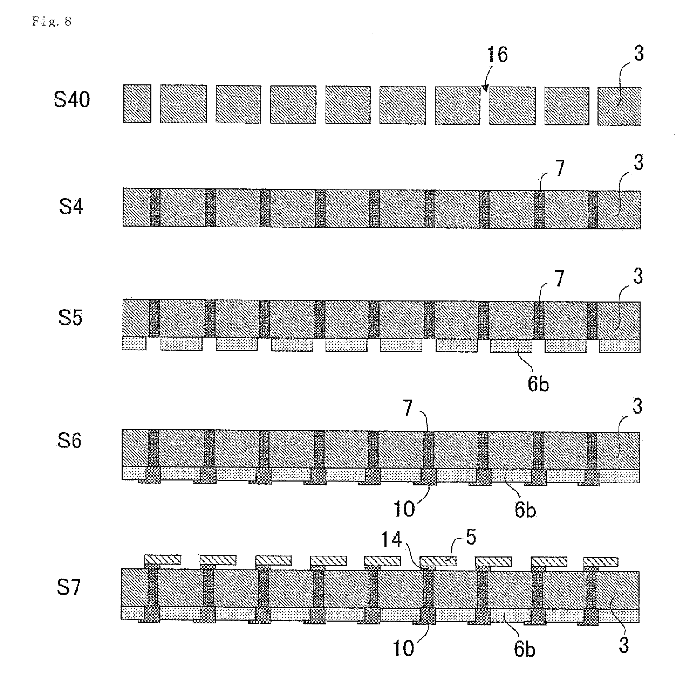

A method of manufacturing the base substrate 3 is described with reference to Fig. 6 and Fig. 8. First, the base substrate 3 in plate shape is prepared, and a plurality of through holes 16 are formed in the base substrate 3 at a through hole forming step S40. The plurality of through holes 16 can be formed simultaneously with the molding method similarly to the formation of the recess portions 9. Instead of the molding method, the plurality of through holes 16 can be formed simultaneously with the sandblasting method or the etching method by placing a mask on the surface. For example, the through holes 16 having a diameter of 50 µm to 0.3 mm are formed with a pitch of approximately 0.5 mm to 2 mm in a vertical direction and a horizontal direction in a soda-lime glass plate having an outer diameter of 4 inches and a thickness of approximately 0.2 mm.

Next, the through hole 16 is filled with a metal material to provide the through electrode 7 at a through electrode forming step S4. For example, a metal rod can be inserted into the through hole 16, and the glass and the metal rod can be hermetically bonded together through heat welding or an adhesive. Then, the surface of the base substrate 3 is planarized by grinding or polishing.

Next, the mold member 6b is placed such that an end face of the through electrode 7 is exposed on a lower face of the base substrate 3 at the mold member placing step S5. An epoxy resin material filled with silica is used as the mold material, is applied to the outer face of the base substrate 3, and is cured through heating to a temperature of approximately 150°C to form the mold member 6b. The mold member 6b is formed to have a thickness of 20 µm to 100 µm, preferably a thickness of 50 µm. The coefficient of linear expansion of the mold member 6b is set by adjusting the type or the amount of the filler in consideration of the state of warping of the base substrate 3 or the state of warping of the base substrate 3 after the bonding to the lid substrate 2. More specifically, when the base substrate 3 is warped with the mount side of the electronic element 5 protruded or when the base substrate 3 bonded to the lid substrate 2 is warped with the side of the lid substrate 2 protruded, the coefficient of linear expansion of the mold member 6b is set to be smaller than the coefficient of linear expansion of the soda-lime glass. Conversely, when the base substrate 3 is warped with the side of the mold member 6b protruded or when the lid substrate 2 and the base substrate 3 bonded together are warped with the side of the base substrate 3 protruded, the coefficient of linear expansion of the mold member 6b is set to be larger than the coefficient of linear expansion of the soda-lime glass.

Next, the electrode terminal 10 is formed on the face of the mold member 6b and the exposed face of the through electrode 7 on the side of the mole member 6b at an electrode terminal forming step S6. The electrode terminal 10 can be formed by depositing a metal film on the outer face of the mold member 6b with the evaporation method, the sputtering method, or the plating method and patterning the film with the photolithography and etching method. Alternatively, the electrode terminal 10 can be provided by printing and thermally treating a pattern formed of a conductive material.

Next, at the mounting step 7, the electronic element 5 is mounted in the form of a cantilever over an upper face of the base substrate 3 with the mounting portion 14 interposed. This causes the connecting electrode, not shown, formed on the face of the electronic element 5 to be electrically connected to the electrode terminal 10 through the mounting portion 14 and the through electrode 7. In the present embodiment, the electronic element 5 is a crystal vibrator with one end fixed to the mounting portion 14 and the other end separated from the base substrate 3 for vibration.

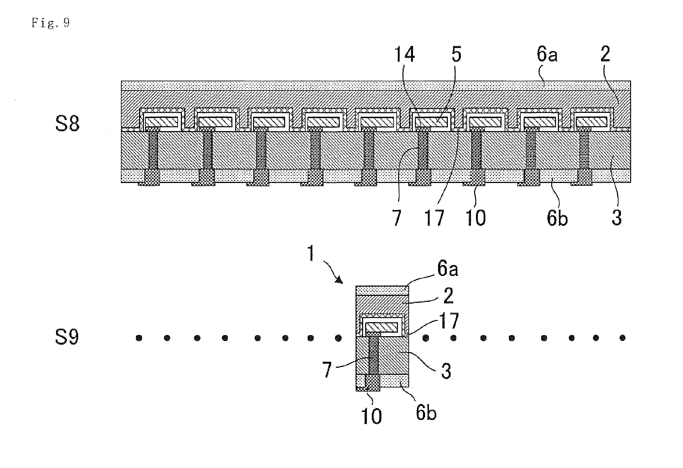

The bonding step S8 and a splitting step S9 for the lid substrate 2 and the base substrate 3 are described with reference to Fig. 6 and Fig. 9. At the bonding step S8, the lid substrate 2 and the base substrate 3 are placed one on another with the metal film 17 interposed between them such that the electronic element 5 mounted on the base substrate 3 is housed in the recess portion 9 of the lid substrate 2. The bonding step S8 is performed under vacuum. Since the mold members 6a and 6b are placed on the outer faces of the lid substrate 2 and the base substrate 3, respectively, each of the substrates is warped only slightly to allow easy alignment thereof. Next, the lid substrate 2 and the base substrate 3 are heated, and a high voltage is applied between the lid substrate 2 and the base substrate 3 to anodic-bond the abutting portions of the substrates. For example, heating is performed to a temperature of 200°C to 250°C, and a voltage of 500V is applied to the lid substrate 2 and the base substrate 3 to perform the anodic bonding. This shields the electronic element 5 from the outside air and holds it under vacuum. Next, the substrates are split into individual electronic devices 1 by a dicer at the splitting step S9.

Since the warping amount of each of the substrates is reduced to facilitate the alignment in this manner, a larger substrate can be used to form a number of electronic devices 1 simultaneously to cut the cost. In addition, variations in stress applied to the electronic element due to a change in ambient temperature can be reduced to stabilize the characteristics of the electronic element to improve the quality of the electronic device.

While the metal film 17 is formed on the lid substrate 2 in the present embodiment, the metal film 17 may be formed on the base substrate 3. While the metal film 17 is formed on the side face and the bottom face of the recess portion 9 of the lid substrate 2 in the present embodiment, the metal film 17 on the bottom face and the side face of the recess portion 9 may be removed since it is only required that the metal film 17 should serve as the bonding material. The anodic bonding is not essential in the invention, and for example, the lid substrate 2 and the base substrate 3 may be bonded together by using an adhesive.

While the mold members 6a and 6b are formed on the outer faces of the substrates before the bonding of the lid substrate 2 and the base substrate 3 in the embodiments described above, the invention is not limited thereto, and the mold members 6a and 6b may be placed on the outer face of the lid substrate 2 or the base substrate 3 after the bonding of the lid substrate 2 and the base substrate 3. This is limited to the case where the lid substrate 2 and the base substrate 3 can be aligned. While the mold material is applied to the substrate face to form the mold member 6 in the embodiments described above, the invention is not limited thereto. For example, the mold member 6 may be formed with transfer molding by placing the lid substrate 2 and the base substrate 3 in a mold and pouring a mold material into the mold.

The foregoing description has been given by way of example only and it will be appreciated by a person skilled in the art that modifications can be made without departing from the scope of the present invention.

## Claims

1. An electronic device (1) comprising:
a lid substrate (2);
a base substrate (3) bonded to the lid substrate and forming a cavity (4) hermetically sealed from the outside air between the base substrate and the lid substrate;
an electronic element (5) housed in the cavity; and
a mold member (6a, 6b) placed on an outer face at least one of the lid substrate and the base substrate.

2. The electronic device according to claim 1, wherein the lid substrate has a recess portion (9) and the recess portion forms the cavity.

3. The electronic device according to claim 1 or 2, wherein the base substrate has a through electrode (7a, 7b) passing from an inner face on a side of the cavity to an outer face on a side opposite to the cavity, and the electronic element is electrically connected to the through electrode.

4. The electronic device according to any one of claims 1 to 3, wherein the lid substrate and the base substrate are bonded together with a bonding material (8) including a metal material interposed between them.

5. The electronic device according to any one of claims 1 to 4, wherein the electronic element is a crystal vibrator mounted in the form of a cantilever on the inner face of the base substrate.

6. The electronic device according to any one of claims 1 to 5, wherein the mold member is formed of an epoxy resin.

7. An oscillator (40) comprising:
the electronic device according to claim 5; and
a driving circuit (41) supplying a driving signal to the electronic device.

8. A method of manufacturing an electronic device comprising:
a recess portion forming step (S1) of forming a recess portion (9) in a lid substrate (2);
a mounting step (S7) of mounting an electronic element (5) on a base substrate (3);
a mold member placing step (S3, S5) of placing a mold member (6a, 6b) on an outer face of the lid substrate or the base substrate; and
a bonding step (S8) of bonding the lid substrate to the base substrate with the electronic element housed in the recess portion.

9. The method of manufacturing the electronic device according to claim 8, wherein the mold member placing step (S3, S5) is performed before the bonding step (S8).

10. The method of manufacturing the electronic device according to claim 8, wherein the mold member placing step (S3, S5) is performed after the bonding step (S8).

11. The method of manufacturing the electronic device according to any one of claims 8 to 10, further comprising a through electrode forming step (S4) of forming a through electrode (7a, 7b) in the base substrate,
wherein the mold member placing step (S5) is a step of placing the mold member (6b) such that the through electrode (7a, 7b) is exposed on an outer face of the base substrate (3) on a side opposite to a side where the electronic element (5) is mounted.

12. The method of manufacturing the electronic device according to any one of claims 8 to 11, wherein the recess portion forming step (S1) is a step of providing a plurality of recess portions (9) in the lid substrate (2), and
the mounting step (S7) is a step of mounting a plurality of the electronic elements on the base substrate (3),
further comprising a splitting step (S9) of cutting and splitting a stack formed of the lid substrate (2) and the base substrate (3) bonded together.
